# EUROPEAN PATENT APPLICATION

(11) **EP 4 412 081 A1**
(43) Date of publication of application: **07.08.2024**
(21) Application number: 22876242.3
(22) Date of filing: 27.09.2022
(51) Int. Cl.: H03F 1/02, H02M 3/07, H03F 3/24

(54) **TRACKER MODULE**

(30) Priority: 29.09.2021 JP 2021159701
(71) Applicant: Murata Manufacturing Co., Ltd., Nagaokakyo-shi, Kyoto 617-8555 (JP)
(72) Inventor: ARAMATA, Tomohide, Nagaokakyo-shi, Kyoto 617-8555 (JP); KOGURE, Takeshi, Nagaokakyo-shi, Kyoto 617-8555 (JP); MATSUI, Toshiki, Nagaokakyo-shi, Kyoto 617-8555 (JP); FUKUDA, Yuuki, Nagaokakyo-shi, Kyoto 617-8555 (JP)
(74) Representative: Stöckeler, Ferdinand
(86) International application number: PCT/JP2022/035976
(87) International publication number: WO 2023/054376

(57) **Abstract**

A tracker module (100) includes an integrated circuit (80) disposed on or in a module substrate (90), and a plurality of external connection terminals including a first external connection terminal and a second external connection terminal. The integrated circuit (80) includes a switch included in a pre-regulator circuit (10), a switch included in a switched-capacitor circuit (20), a switch included in a supply modulator (30), a first IC electrode connected to the first external connection terminal, and a second IC electrode connected to the second external connection terminal. The first external connection terminal is connected to a power inductor (L71) that is disposed outside the tracker module (100). The second external connection terminal is an input terminal for a digital control signal for the supply modulator (30). A distance between the first external connection terminal and the first IC electrode is shorter than a distance between the second external connection terminal and the second IC electrode.

## Description

### Technical Field

The present invention relates to a tracker module.

### Background Art

Patent Document 1 discloses a power supply modulation circuit capable of supplying a power amplifier (PA) with a power supply voltage that is dynamically adjusted over time in accordance with a radio frequency (RF) signal.

### Citation List

### Patent Document

Patent Document 1: United States Patent No. 9,755,672

### Summary of Invention

### Technical Problem

In modularization of the power supply modulation circuit (power supply circuit) of Patent Document 1, it may be impossible to mount all circuit elements included in the power supply circuit in one module. In such a case, characteristics related to the connection between a circuit component inside the module and a circuit component outside the module may deteriorate.

Accordingly, the present invention provides a tracker module capable of reducing deterioration of characteristics related to the connection between a circuit component inside the module and a circuit component outside the module. Solution to Problem

A tracker module according to an aspect of the present invention includes a module substrate, at least one integrated circuit disposed on or in the module substrate, and a plurality of external connection terminals including a first external connection terminal and a second external connection terminal. The at least one integrated circuit includes at least one switch included in a pre-regulator circuit configured to convert an input voltage into a first voltage by using a power inductor; at least one switch included in a switched-capacitor circuit configured to generate a plurality of discrete voltages from the first voltage; at least one switch included in a supply modulator configured to selectively output, based on a digital control signal corresponding to an envelope signal, at least one of the plurality of discrete voltages; a first integrated circuit terminal connected to the first external connection terminal; and a second integrated circuit terminal connected to the second external connection terminal. The first external connection terminal is connected to the power inductor that is disposed outside the tracker module. The second external connection terminal is an input terminal for the digital control signal. A first distance between the first external connection terminal and the first integrated circuit terminal is shorter than a second distance between the second external connection terminal and the second integrated circuit terminal.

A tracker module according to an aspect of the present invention includes a module substrate, at least one integrated circuit disposed on or in the module substrate, and a plurality of external connection terminals including a first external connection terminal and a second external connection terminal. The at least one integrated circuit includes at least one switch included in a pre-regulator circuit, at least one switch included in a switched-capacitor circuit, at least one switch included in a supply modulator, a first integrated circuit terminal connected to the first external connection terminal, and a second integrated circuit terminal connected to the second external connection terminal. The switched-capacitor circuit includes a first capacitor having a first electrode and a second electrode, and a second capacitor having a third electrode and a fourth electrode. The at least one switch included in the switched-capacitor circuit includes a first switch, a second switch, a third switch, a fourth switch, a fifth switch, a sixth switch, a seventh switch, and an eighth switch. One terminal of the first switch and one terminal of the third switch are connected to the first electrode. One terminal of the second switch and one terminal of the fourth switch are connected to the second electrode. One terminal of the fifth switch and one terminal of the seventh switch are connected to the third electrode. One terminal of the sixth switch and one terminal of the eighth switch are connected to the fourth electrode. The other terminal of the first switch, the other terminal of the second switch, the other terminal of the fifth switch, and the other terminal of the sixth switch are connected to each other. The other terminal of the third switch is connected to the other terminal of the seventh switch. The other terminal of the fourth switch is connected to the other terminal of the eighth switch. The supply modulator includes an output terminal. The at least one switch included in the supply modulator includes a ninth switch connected between the output terminal and each of the other terminal of the first switch, the other terminal of the second switch, the other terminal of the fifth switch, and the other terminal of the sixth switch; and a tenth switch connected between the output terminal and each of the other terminal of the third switch and the other terminal of the seventh switch. The pre-regulator circuit includes an input terminal. The at least one switch included in the pre-regulator circuit includes an eleventh switch connected between the input terminal and one end of a power inductor, and a twelfth switch connected between the one end of the power inductor and ground. The other end of the power inductor is connected to the other terminal of the first switch, the other terminal of the second switch, the other terminal of the fifth switch, and the other terminal of the sixth switch. The first external connection terminal is connected to the power inductor that is disposed outside the tracker module. The second external connection terminal is an input terminal for a digital control signal for the supply modulator. A first distance between the first external connection terminal and the first integrated circuit terminal is shorter than a second distance between the second external connection terminal and the second integrated circuit terminal.

### Advantageous Effects of Invention

A tracker module according to an aspect of the present invention is capable of reducing deterioration of characteristics related to the connection between a circuit component inside the module and a circuit component outside the module.

### Brief Description of Drawings

[Fig. 1] Fig. 1 is a circuit configuration diagram of a communication device according to an embodiment.
[Fig. 2] Fig. 2 is a circuit configuration diagram of a pre-regulator circuit, a switched-capacitor circuit, a supply modulator, and a filter circuit according to the embodiment.
[Fig. 3A] Fig. 3A is a graph illustrating a power supply voltage supplied by digital envelope tracking.
[Fig. 3B] Fig. 3B is a graph illustrating a power supply voltage supplied by analog envelope tracking.
[Fig. 4] Fig. 4 is a plan view of a tracker module according to an example.
[Fig. 5] Fig. 5 is a plan view of the tracker module according to the example.
[Fig. 6] Fig. 6 is a sectional view of the tracker module according to the example.
[Fig. 7] Fig. 7 is a sectional view of the tracker module according to the example.
[Fig. 8] Fig. 8 is a sectional view of the tracker module according to the example.
[Fig. 9] Fig. 9 is a sectional view of the tracker module according to the example.
[Fig. 10] Fig. 10 is a plan view of a plurality of electrodes and a plurality of wiring lines included in the tracker module according to the example.
[Fig. 11] Fig. 11 is an enlarged plan view of a land electrode, bump electrodes, and a wiring line connecting the land electrode and the bump electrodes included in the tracker module according to the example.
[Fig. 12] Fig. 12 is an enlarged plan view of a land electrode, bump electrodes, and a wiring line connecting the land electrode and the bump electrodes included in the tracker module according to the example.
[Fig. 13] Fig. 13 is an enlarged plan view of a land electrode, a bump electrode, and a wiring line connecting the land electrode and the bump electrode included in the tracker module according to the example.
[Fig. 14] Fig. 14 is an enlarged plan view of a land electrode, a bump electrode, and a wiring line connecting the land electrode and the bump electrode included in the tracker module according to the example.

### Description of Embodiments

Hereinafter, embodiments of the present invention will be described in detail with reference to the drawings. The embodiments described below each illustrate a general or specific example. The numerical values, shapes, materials, constituent elements, the arrangement and connection manner of the constituent elements, and so forth described in the following embodiments are merely examples, and are not intended to limit the present invention.

The drawings are schematic diagrams drawn with emphasis, omission, or ratio adjustment performed as appropriate in order to illustrate the present invention. The illustration therein is not necessarily strict, and may be different from actual shapes, positional relationships, and ratios. In the drawings, constituent elements that are substantially the same are denoted by the same reference numerals, and a repeated description thereof may be omitted or simplified.

In the drawings referred to below, an x-axis and a y-axis are axes orthogonal to each other on a plane parallel to main surfaces of a module substrate. Specifically, in a case where the module substrate has a rectangular shape in plan view, the x-axis is parallel to a first side of the module substrate, and the y-axis is parallel to a second side orthogonal to the first side of the module substrate. A z-axis is an axis perpendicular to the main surfaces of the module substrate. The positive direction thereof indicates an upward direction, and the negative direction thereof indicates a downward direction.

Regarding the circuit configurations of the present invention, "connected" includes not only a direct connection using a connection terminal and/or a wiring conductor, but also an electrical connection via another circuit element. "Connected between A and B" means connected to both A and B between A and B, and includes a series connection to a path connecting A and B and a parallel connection (shunt connection) between the path and ground.

Regarding the disposition of components in the present invention, "a component is disposed on or in a substrate" includes that the component is disposed on a main surface of the substrate and that the component is disposed in the substrate. "A component is disposed on a main surface of a substrate" includes not only that the component is disposed in contact with the main surface of the substrate but also that the component is disposed above the main surface without being in contact with the main surface (for example, the component is stacked on another component disposed in contact with the main surface). "A component is disposed on a main surface of a substrate" may include that the component is disposed in a recessed portion formed on the main surface. "A component is disposed in a substrate" includes not only that the component is encapsulated in the module substrate but also that the entire component is disposed between both main surfaces of the substrate but a part of the component is not covered with the substrate and that only a part of the component is disposed in the substrate. "In plan view of a module substrate" means that an object is viewed by orthographic projection on an xy plane from a z-axis positive side. In addition, terms indicating the relationships between elements, such as "parallel" and "perpendicular", terms indicating the shapes of elements, such as "rectangular", and numerical ranges do not represent only strict meanings, but include substantially equivalent ranges, for example, an error of about several percent.

### (Embodiment)

Hereinafter, a tracker module and a communication device according to an embodiment will be described with reference to the drawings.

### [1. Circuit configurations of communication device 7 and power supply circuit 1]

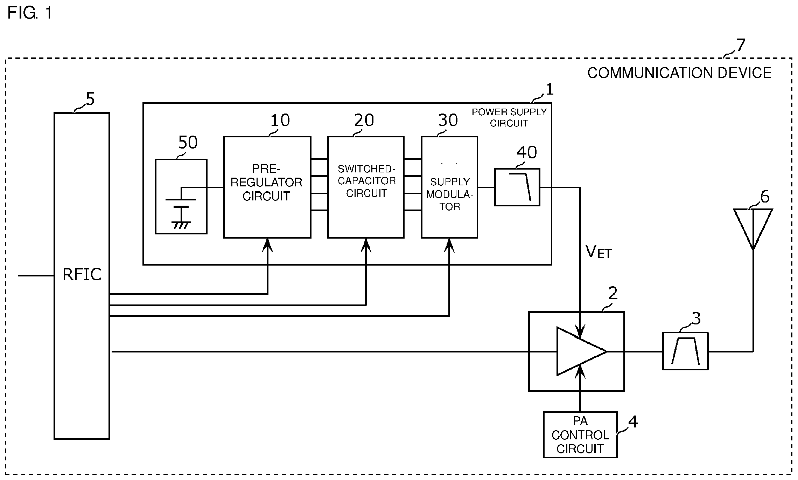

The circuit configuration of a communication device 7 according to the present embodiment will be described with reference to Fig. 1. Fig. 1 is a circuit configuration diagram of the communication device 7 according to the present embodiment.

### [1.1. Circuit configuration of communication device 7]

First, the circuit configuration of the communication device 7 will be described. As illustrated in Fig. 1, the communication device 7 according to the present embodiment includes a power supply circuit 1, a power amplifier (PA) 2, a filter 3, a PA control circuit 4, a radio frequency integrated circuit (RFIC) 5, and an antenna 6.

The power supply circuit 1 is capable of supplying a power supply voltage V_{ET} to the PA 2 in a digital envelope tracking (ET) mode. In the digital ET mode, the voltage level of the power supply voltage V_{ET} is selected from among a plurality of discrete voltage levels based on a digital control signal corresponding to an envelope signal, and changes with time.

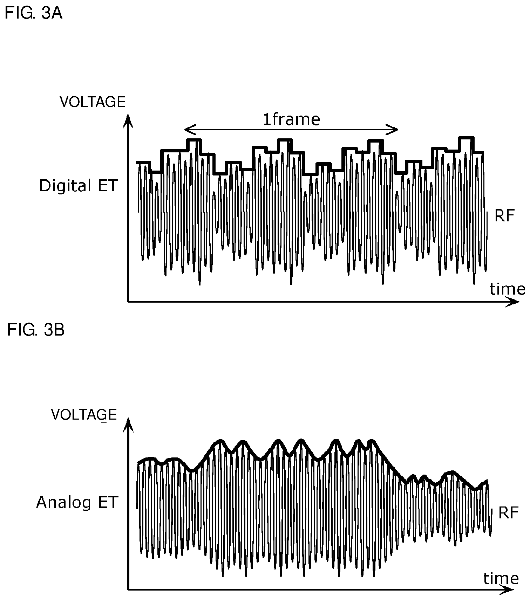

The envelope signal is a signal indicating the envelope value of a modulated signal (RF signal). The envelope value is represented by, for example, the square root of (I² + Q²). (I, Q) represents a constellation point herein. The constellation point is a point representing, on a constellation diagram, a signal modulated by digital modulation. The details of the digital ET mode will be described below with reference to Fig. 3A and Fig. 3B.

Although the power supply circuit 1 supplies one power supply voltage V_{ET} to the one PA 2 in Fig. 1, the power supply circuit 1 may supply the same power supply voltage V_{ET} to a plurality of PAs. The power supply circuit 1 may be configured to be capable of supplying different power supply voltages to a plurality of PAs.

As illustrated in Fig. 1, the power supply circuit 1 includes a pre-regulator circuit 10, a switched-capacitor circuit 20, a supply modulator 30, a filter circuit 40, and a direct current (DC) power source 50.

The pre-regulator circuit 10 includes a power inductor and a switch. The power inductor is an inductor used to raise and/or lower a DC voltage. The power inductor is disposed in series with a DC path. Alternatively, the power inductor may be connected between a series path and ground (disposed in parallel). The pre-regulator circuit 10 is capable of converting an input voltage into a first voltage by using the power inductor. Such a pre-regulator circuit 10 may also be referred to as a magnetic regulator or a DC-DC converter.

The switched-capacitor circuit 20 includes a plurality of capacitors and a plurality of switches, and is capable of generating, from the first voltage received from the pre-regulator circuit 10, a plurality of second voltages as a plurality of discrete voltages each having a corresponding one of a plurality of discrete voltage levels. The switched-capacitor circuit 20 may also be referred to as a switched-capacitor voltage balancer.

The supply modulator 30 is capable of selecting at least one of the plurality of second voltages generated by the switched-capacitor circuit 20 and outputting the selected voltage to the filter circuit 40, based on a digital control signal corresponding to an envelope signal.

The filter circuit 40 is capable of filtering a signal (second voltage) received from the supply modulator 30. The filter circuit 40 includes, for example, a low pass filter (LPF) .

The DC power source 50 is capable of supplying a DC voltage to the pre-regulator circuit 10. The DC power source 50 may be, but is not limited to, a rechargeable battery, for example.

The power supply circuit 1 does not necessarily have to include at least one of the pre-regulator circuit 10, the switched-capacitor circuit 20, the supply modulator 30, the filter circuit 40, and the DC power source 50. For example, the power supply circuit 1 does not necessarily have to include the filter circuit 40 or the DC power source 50. Any combination of the pre-regulator circuit 10, the switched-capacitor circuit 20, the supply modulator 30, and the filter circuit 40 may be integrated into a single circuit.

The PA 2 is connected between the RFIC 5 and the filter 3. The PA 2 is capable of receiving the power supply voltage V_{ET} from the power supply circuit 1 and receiving a bias signal from the PA control circuit 4. Accordingly, the PA 2 is capable of amplifying a transmission signal of a predetermined band received from the RFIC 5.

The filter 3 is connected between the PA 2 and the antenna 6. The filter 3 has a passband including the predetermined band. Accordingly, the filter 3 is capable of passing the transmission signal of the predetermined band amplified by the PA 2.

The PA control circuit 4 is capable of controlling the PA 2. Specifically, the PA control circuit 4 is capable of supplying a bias signal to the PA 2.

The RFIC 5 is an example of a signal processing circuit that processes an RF signal. Specifically, the RFIC 5 performs signal processing such as up-conversion on a transmission signal input thereto, and supplies an RF transmission signal generated through the signal processing to the PA 2. The RFIC 5 includes a control unit that controls the power supply circuit 1. Some or all of the functions of the control unit of the RFIC 5 may be implemented outside the RFIC 5.

The antenna 6 transmits the signal of the predetermined band input from the PA 2 through the filter 3.

The predetermined band is a frequency band for a communication system constructed using the radio access technology (RAT). The predetermined band is defined in advance by a standardizing body (for example, 3rd Generation Partnership Project (3GPP, registered trademark), Institute of Electrical and Electronics Engineers (IEEE), or the like). Examples of the communication system include a 5th Generation New Radio (5G NR) system, a Long Term Evolution (LTE) system, and a Wireless Local Area Network (WLAN) system.

The circuit configuration of the communication device 7 illustrated in Fig. 1 is illustrative, and is not restrictive. For example, the communication device 7 does not necessarily have to include the antenna 6. For example, the communication device 7 may include a plurality of antennas.

### [1.2. Circuit configuration of power supply circuit 1]

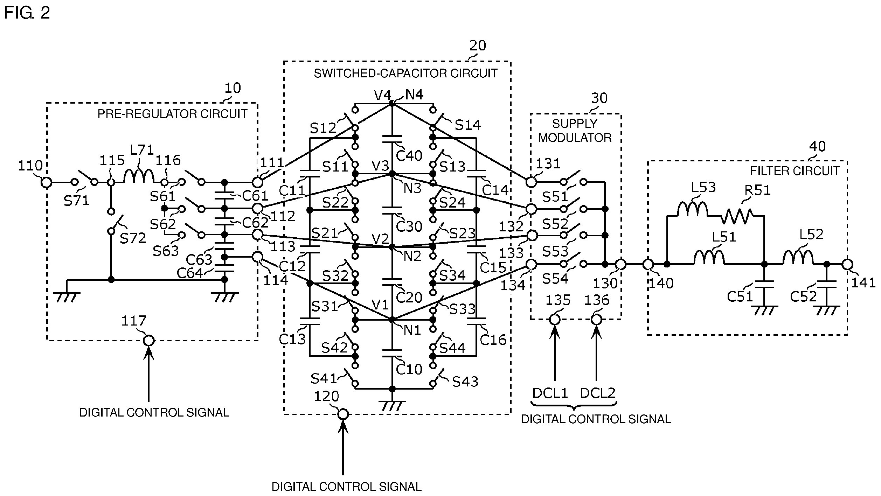

Next, the circuit configurations of the pre-regulator circuit 10, the switched-capacitor circuit 20, the supply modulator 30, and the filter circuit 40 included in the power supply circuit 1 will be described with reference to Fig. 2. Fig. 2 is a circuit configuration diagram of the pre-regulator circuit 10, the switched-capacitor circuit 20, the supply modulator 30, and the filter circuit 40 according to the present embodiment.

Fig. 2 illustrates exemplary circuit configurations. The pre-regulator circuit 10, the switched-capacitor circuit 20, the supply modulator 30, and the filter circuit 40 may be mounted by using any one of a wide variety of circuit packaging methods and circuit techniques. Thus, the description of the individual circuits provided below should not be construed in a limiting manner.

### [1.2.1. Circuit configuration of switched-capacitor circuit 20]

First, the circuit configuration of the switched-capacitor circuit 20 will be described. As illustrated in Fig. 2, the switched-capacitor circuit 20 includes capacitors C11 to C16, capacitors C10, C20, C30, and C40, switches S11 to S14, S21 to S24, S31 to S34, and S41 to S44, and a control terminal 120. Energy and electric charge are input from the pre-regulator circuit 10 to the switched-capacitor circuit 20 at nodes N1 to N4 and output from the switched-capacitor circuit 20 to the supply modulator 30 at the nodes N1 to N4.

The control terminal 120 is an input terminal for a digital control signal. More specifically, the control terminal 120 is a terminal for receiving a digital control signal for controlling the switched-capacitor circuit 20. The digital control signal received via the control terminal 120 is, for example, a control signal of a source synchronous scheme in which a data signal and a clock signal are transmitted, but is not limited thereto. For example, the digital control signal may be a control signal of a clock embedded scheme in which a clock is embedded in a data signal.

The capacitors C11 to C16 each function as a flying capacitor (also referred to as a transfer capacitor). Specifically, the capacitors C11 to C16 are each used to raise or lower the first voltage supplied from the pre-regulator circuit 10. More specifically, the capacitors C11 to C16 cause electric charges to move between the capacitors C11 to C16 and the nodes N1 to N4 so that voltages V1 to V4 (voltages with respect to a ground potential) satisfying V1:V2:V3:V4 = 1:2:3:4 are maintained at the four nodes N1 to N4. The voltages V1 to V4 correspond to the plurality of second voltages each having a corresponding one of a plurality of discrete voltage levels.

The capacitor C11 has two electrodes. One of the two electrodes of the capacitor C11 is connected to one terminal of the switch S11 and one terminal of the switch S12. The other of the two electrodes of the capacitor C11 is connected to one terminal of the switch S21 and one terminal of the switch S22.

The capacitor C12 is an example of a first capacitor and has two electrodes (an example of a first electrode and a second electrode). One of the two electrodes of the capacitor C12 is connected to the one terminal of the switch S21 and the one terminal of the switch S22. The other of the two electrodes of the capacitor C12 is connected to one terminal of the switch S31 and one terminal of the switch S32.

The capacitor C13 has two electrodes. One of the two electrodes of the capacitor C13 is connected to the one terminal of the switch S31 and the one terminal of the switch S32. The other of the two electrodes of the capacitor C13 is connected to one terminal of the switch S41 and one terminal of the switch S42.

The capacitor C14 has two electrodes. One of the two electrodes of the capacitor C14 is connected to one terminal of the switch S13 and one terminal of the switch S14. The other of the two electrodes of the capacitor C14 is connected to one terminal of the switch S23 and one terminal of the switch S24.

The capacitor C15 is an example of a second capacitor and has two electrodes (an example of a third electrode and a fourth electrode). One of the two electrodes of the capacitor C15 is connected to the one terminal of the switch S23 and the one terminal of the switch S24. The other of the two electrodes of the capacitor C15 is connected to one terminal of the switch S33 and one terminal of the switch S34.

The capacitor C16 has two electrodes. One of the two electrodes of the capacitor C16 is connected to the one terminal of the switch S33 and the one terminal of the switch S34. The other of the two electrodes of the capacitor C16 is connected to one terminal of the switch S43 and one terminal of the switch S44.

A set of the capacitors C11 and C14, a set of the capacitors C12 and C15, and a set of the capacitors C13 and C16 can each be charged and discharged in a complementary manner as a result of a first phase and a second phase being repeated.

Specifically, in the first phase, the switches S12, S13, S22, S23, S32, S33, S42, and S43 are turned ON. Accordingly, for example, the one of the two electrodes of the capacitor C12 is connected to the node N3, the other of the two electrodes of the capacitor C12 and the one of the two electrodes of the capacitor C15 are connected to the node N2, and the other of the two electrodes of the capacitor C15 is connected to the node N1.

On the other hand, in the second phase, the switches S11, S14, S21, S24, S31, S34, S41, and S44 are turned ON. Accordingly, for example, the one of the two electrodes of the capacitor C15 is connected to the node N3, the other of the two electrodes of the capacitor C15 and the one of the two electrodes of the capacitor C12 are connected to the node N2, and the other of the two electrodes of the capacitor C12 is connected to the node N1.

As a result of the first phase and the second phase being repeated, for example, when one of the capacitors C12 and C15 is charged through the node N2, the other of the capacitors C12 and C15 can be discharged to the capacitor C30. In short, the capacitors C12 and C15 can be charged and discharged in a complementary manner.

Similarly to the set of the capacitors C12 and C15, the set of the capacitors C11 and C14 and the set of the capacitors C13 and C16 can each be charged and discharged in a complementary manner as a result of the first phase and the second phase being repeated.

The capacitors C10, C20, C30, and C40 each function as a smoothing capacitor. Specifically, the capacitors C10, C20, C30, and C40 are used to hold and smooth the voltages V1 to V4 at the nodes N1 to N4, respectively.

The capacitor C10 is connected between the node N1 and ground. Specifically, one of the two electrodes of the capacitor C10 is connected to the node N1. On the other hand, the other of the two electrodes of the capacitor C10 is connected to ground.

The capacitor C20 is connected between the nodes N2 and N1. Specifically, one of the two electrodes of the capacitor C20 is connected to the node N2. On the other hand, the other of the two electrodes of the capacitor C20 is connected to the node N1.

The capacitor C30 is connected between the nodes N3 and N2. Specifically, one of the two electrodes of the capacitor C30 is connected to the node N3. On the other hand, the other of the two electrodes of the capacitor C30 is connected to the node N2.

The capacitor C40 is connected between the nodes N4 and N3. Specifically, one of the two electrodes of the capacitor C40 is connected to the node N4. On the other hand, the other of the two electrodes of the capacitor C40 is connected to the node N3.

The switch S11 is connected between the one of the two electrodes of the capacitor C11 and the node N3. Specifically, the one terminal of the switch S11 is connected to the one of the two electrodes of the capacitor C11. On the other hand, the other terminal of the switch S11 is connected to the node N3.

The switch S12 is connected between the one of the two electrodes of the capacitor C11 and the node N4. Specifically, the one terminal of the switch S12 is connected to the one of the two electrodes of the capacitor C11. On the other hand, the other terminal of the switch S12 is connected to the node N4.

The switch S21 is an example of a first switch and is connected between the one of the two electrodes of the capacitor C12 and the node N2. Specifically, the one terminal of the switch S21 is connected to the one of the two electrodes of the capacitor C12 and the other of the two electrodes of the capacitor C11. On the other hand, the other terminal of the switch S21 is connected to the node N2.

The switch S22 is an example of a third switch and is connected between the one of the two electrodes of the capacitor C12 and the node N3. Specifically, the one terminal of the switch S22 is connected to the one of the two electrodes of the capacitor C12 and the other of the two electrodes of the capacitor C11. On the other hand, the other terminal of the switch S22 is connected to the node N3.

The switch S31 is an example of a fourth switch and is connected between the other of the two electrodes of the capacitor C12 and the node N1. Specifically, the one terminal of the switch S31 is connected to the other of the two electrodes of the capacitor C12 and the one of the two electrodes of the capacitor C13. On the other hand, the other terminal of the switch S31 is connected to the node N1.

The switch S32 is an example of a second switch and is connected between the other of the two electrodes of the capacitor C12 and the node N2. Specifically, the one terminal of the switch S32 is connected to the other of the two electrodes of the capacitor C12 and the one of the two electrodes of the capacitor C13. On the other hand, the other terminal of the switch S32 is connected to the node N2. That is, the other terminal of the switch S32 is connected to the other terminal of the switch S21.

The switch S41 is connected between the other of the two electrodes of the capacitor C13 and ground. Specifically, the one terminal of the switch S41 is connected to the other of the two electrodes of the capacitor C13. On the other hand, the other terminal of the switch S41 is connected to ground.

The switch S42 is connected between the other of the two electrodes of the capacitor C13 and the node N1. Specifically, the one terminal of the switch S42 is connected to the other of the two electrodes of the capacitor C13. On the other hand, the other terminal of the switch S42 is connected to the node N1. That is, the other terminal of the switch S42 is connected to the other terminal of the switch S31.

The switch S13 is connected between the one of the two electrodes of the capacitor C14 and the node N3. Specifically, the one terminal of the switch S13 is connected to the one of the two electrodes of the capacitor C14. On the other hand, the other terminal of the switch S13 is connected to the node N3. That is, the other terminal of the switch S13 is connected to the other terminal of the switch S11 and the other terminal of the switch S22.

The switch S14 is connected between the one of the two electrodes of the capacitor C14 and the node N4. Specifically, the one terminal of the switch S14 is connected to the one of the two electrodes of the capacitor C14. On the other hand, the other terminal of the switch S14 is connected to the node N4. That is, the other terminal of the switch S14 is connected to the other terminal of the switch S12.

The switch S23 is an example of a fifth switch and is connected between the one of the two electrodes of the capacitor C15 and the node N2. Specifically, the one terminal of the switch S23 is connected to the one of the two electrodes of the capacitor C15 and the other of the two electrodes of the capacitor C14. On the other hand, the other terminal of the switch S23 is connected to the node N2. That is, the other terminal of the switch S23 is connected to the other terminal of the switch S21 and the other terminal of the switch S32.

The switch S24 is an example of a seventh switch and is connected between the one of the two electrodes of the capacitor C15 and the node N3. Specifically, the one terminal of the switch S24 is connected to the one of the two electrodes of the capacitor C15 and the other of the two electrodes of the capacitor C14. On the other hand, the other terminal of the switch S24 is connected to the node N3. That is, the other terminal of the switch S24 is connected to the other terminal of the switch S11, the other terminal of the switch S22, and the other terminal of the switch S13.

The switch S33 is an example of an eighth switch and is connected between the other of the two electrodes of the capacitor C15 and the node N1. Specifically, the one terminal of the switch S33 is connected to the other of the two electrodes of the capacitor C15 and the one of the two electrodes of the capacitor C16. On the other hand, the other terminal of the switch S33 is connected to the node N1. That is, the other terminal of the switch S33 is connected to the other terminal of the switch S31 and the other terminal of the switch S42.

The switch S34 is an example of a sixth switch and is connected between the other of the two electrodes of the capacitor C15 and the node N2. Specifically, the one terminal of the switch S34 is connected to the other of the two electrodes of the capacitor C15 and the one of the two electrodes of the capacitor C16. On the other hand, the other terminal of the switch S34 is connected to the node N2. That is, the other terminal of the switch S34 is connected to the other terminal of the switch S21, the other terminal of the switch S32, and the other terminal of the switch S23.

The switch S43 is connected between the other of the two electrodes of the capacitor C16 and ground. Specifically, the one terminal of the switch S43 is connected to the other of the two electrodes of the capacitor C16. On the other hand, the other terminal of the switch S43 is connected to ground.

The switch S44 is connected between the other of the two electrodes of the capacitor C16 and the node N1. Specifically, the one terminal of the switch S44 is connected to the other of the two electrodes of the capacitor C16. On the other hand, the other terminal of the switch S44 is connected to the node N1. That is, the other terminal of the switch S44 is connected to the other terminal of the switch S31, the other terminal of the switch S42, and the other terminal of the switch S33.

A first set of switches including the switches S12, S13, S22, S23, S32, S33, S42, and S43, and a second set of switches including the switches S11, S14, S21, S24, S31, S34, S41, and S44 are turned ON and OFF in a complementary manner. Specifically, in the first phase, the switches in the first set are turned ON whereas the switches in the second set are turned OFF. Conversely, in the second phase, the switches in the first set are turned OFF whereas the switches in the second set are turned ON.

For example, in one of the first phase and the second phase, charging from the capacitors C11 to C13 to the capacitors C10 to C40 is performed, and in the other of the first phase and the second phase, charging from the capacitors C14 to C16 to the capacitors C10 to C40 is performed. In other words, because the capacitors C10 to C40 are constantly charged by the capacitors C11 to C13 or the capacitors C14 to C16, the nodes N1 to N4 are rapidly replenished with electric charges even if currents rapidly flow from the nodes N1 to N4 to the supply modulator 30. Thus, potential variations at the nodes N1 to N4 can be reduced.

As a result of operating in the above-described manner, the switched-capacitor circuit 20 is capable of maintaining substantially equal voltages across each of the capacitors C10, C20, C30, and C40. Specifically, the voltages V1 to V4 (voltages with respect to a ground potential) satisfying V1:V2:V3:V4 = 1:2:3:4 are maintained at the four nodes labeled V1 to V4. The levels of the voltages V1 to V4 correspond to a plurality of discrete voltage levels that can be supplied to the supply modulator 30 by the switched-capacitor circuit 20.

The voltage ratio V1:V2:V3:V4 is not limited to 1:2:3:4. For example, the voltage ratio V1:V2:V3:V4 may be 1:2:4:8.

The configuration of the switched-capacitor circuit 20 illustrated in Fig. 2 is illustrative, and is not restrictive. In Fig. 2, the switched-capacitor circuit 20 is configured to be capable of supplying voltages of four discrete voltage levels, but the configuration is not limited thereto. The switched-capacitor circuit 20 may be configured to be capable of supplying voltages of any number of two or more discrete voltage levels. For example, in the case of supplying voltages of two discrete voltage levels, it is sufficient that the switched-capacitor circuit 20 include at least the capacitors C12 and C15 and the switches S21 to S24 and S31 to S34.

### [1.2.2. Circuit configuration of supply modulator 30]

Next, the circuit configuration of the supply modulator 30 will be described. As illustrated in Fig. 2, the supply modulator 30 includes input terminals 131 to 134, switches S51 to S54, an output terminal 130, and control terminals 135 and 136.

The output terminal 130 is connected to the filter circuit 40. The output terminal 130 is a terminal for supplying the filter circuit 40 with a voltage selected from among the voltages V1 to V4.

The input terminals 131 to 134 are connected to the nodes N4 to N1 of the switched-capacitor circuit 20, respectively. The input terminals 131 to 134 are terminals for receiving the voltages V4 to V1 from the switched-capacitor circuit 20, respectively.

The control terminals 135 and 136 are input terminals for digital control signals. That is, the control terminals 135 and 136 are terminals for receiving digital control signals indicating one of the voltages V1 to V4. The supply modulator 30 controls ON/OFF of the switches S51 to S54 so as to select the voltage level indicated by the digital control signals.

The digital control signals received via the control terminals 135 and 136 may be two digitally controlled level (DCL) signals. The two DCL signals are each a 1-bit signal. The voltages V1 to V4 are each represented by a combination of two 1-bit signals. For example, V1, V2, V3, and V4 are represented by "00", "01", "10", and "11", respectively. A gray code may be used to express a voltage level.

Such a DCL signal does not require a clock signal, and thus the DCL signal emits less noise and has higher noise tolerance than a source-synchronous control signal. Thus, a wiring line for transmitting a DCL signal has a higher tolerance for an increase in wiring length than a wiring line for transmitting a source-synchronous control signal.

Although two DCL signals are used in the present embodiment, the present invention is not limited thereto. For example, any number of three or more DCL signals may be used depending on the number of voltage levels. The digital control signals are not limited to DCL signals and may be source-synchronous control signals.

The switch S51 is connected between the input terminal 131 and the output terminal 130. Specifically, the switch S51 has a terminal connected to the input terminal 131 and a terminal connected to the output terminal 130. In this connection configuration, ON/OFF switching of the switch S51 enables switching between connection and disconnection between the input terminal 131 and the output terminal 130.

The switch S52 is an example of a tenth switch and is connected between the input terminal 132 and the output terminal 130. Specifically, the switch S52 has a terminal connected to the input terminal 132 and a terminal connected to the output terminal 130. In this connection configuration, ON/OFF switching of the switch S52 enables switching between connection and disconnection between the input terminal 132 and the output terminal 130.

The switch S53 is an example of a ninth switch and is connected between the input terminal 133 and the output terminal 130. Specifically, the switch S53 has a terminal connected to the input terminal 133 and a terminal connected to the output terminal 130. In this connection configuration, ON/OFF switching of the switch S53 enables switching between connection and disconnection between the input terminal 133 and the output terminal 130.

The switch S54 is connected between the input terminal 134 and the output terminal 130. Specifically, the switch S54 has a terminal connected to the input terminal 134 and a terminal connected to the output terminal 130. In this connection configuration, ON/OFF switching of the switch S54 enables switching between connection and disconnection between the input terminal 134 and the output terminal 130.

These switches S51 to S54 are controlled so as to be exclusively turned ON. In other words, only any one of the switches S51 to S54 is turned ON, and the others are turned OFF. Accordingly, the supply modulator 30 is capable of outputting one voltage selected from among the voltages V1 to V4.

The configuration of the supply modulator 30 illustrated in Fig. 2 is illustrative, and is not restrictive. In particular, the switches S51 to S54 may have any configuration as long as at least one of the four input terminals 131 to 134 can be selected and connected to the output terminal 130. For example, the supply modulator 30 may further include a switch connected between a set of the switches S51 to S53 and a set of the switch S54 and the output terminal 130. For example, the supply modulator 30 may further include a switch connected between a set of the switches S51 and S52 and a set of the switches S53 and S54 and the output terminal 130.

The supply modulator 30 may be configured to be capable of outputting two or more voltages. In this case, the supply modulator 30 may further include a necessary number of additional switch sets having the same configuration as the set of the switches S51 to S54 and additional output terminals.

In a case where voltages of two discrete voltage levels are supplied from the switched-capacitor circuit 20, it is sufficient that the supply modulator 30 include at least the switches S52 and S53.

### [1.2.3. Circuit configuration of pre-regulator circuit 10]

The configuration of the pre-regulator circuit 10 will be described. As illustrated in Fig. 2, the pre-regulator circuit 10 includes an input terminal 110, output terminals 111 to 114, inductor connection terminals 115 and 116, a control terminal 117, switches S61 to S63, S71, and S72, a power inductor L71, and capacitors C61 to C64.

The input terminal 110 is an input terminal for a DC voltage. Specifically, the input terminal 110 is a terminal for receiving an input voltage from the DC power source 50.

The output terminal 111 is an output terminal for the voltage V4. Specifically, the output terminal 111 is a terminal for supplying the voltage V4 to the switched-capacitor circuit 20. The output terminal 111 is connected to the node N4 of the switched-capacitor circuit 20.

The output terminal 112 is an output terminal for the voltage V3. Specifically, the output terminal 112 is a terminal for supplying the voltage V3 to the switched-capacitor circuit 20. The output terminal 112 is connected to the node N3 of the switched-capacitor circuit 20.

The output terminal 113 is an output terminal for the voltage V2. Specifically, the output terminal 113 is a terminal for supplying the voltage V2 to the switched-capacitor circuit 20. The output terminal 113 is connected to the node N2 of the switched-capacitor circuit 20.

The output terminal 114 is an output terminal for the voltage V1. Specifically, the output terminal 114 is a terminal for supplying the voltage V1 to the switched-capacitor circuit 20. The output terminal 114 is connected to the node N1 of the switched-capacitor circuit 20.

The inductor connection terminal 115 is connected to one end of the power inductor L71. The inductor connection terminal 116 is connected to the other end of the power inductor L71.

The control terminal 117 is an input terminal for a digital control signal. Specifically, the control terminal 117 is a terminal for receiving a digital control signal for controlling the pre-regulator circuit 10. The digital control signal received via the control terminal 117 is, for example, a control signal of a source synchronous scheme in which a data signal and a clock signal are transmitted, but is not limited thereto. For example, the digital control signal may be a control signal of a clock embedded scheme in which a clock is embedded in a data signal. The control terminal 117 may be integrated with the control terminal 120.

The switch S71 is an example of an eleventh switch and is connected between the input terminal 110 and the one end of the power inductor L71. Specifically, the switch S71 has a terminal connected to the input terminal 110, and a terminal connected to the one end of the power inductor L71 via the inductor connection terminal 115. In this connection configuration, ON/OFF switching of the switch S71 enables switching between connection and disconnection between the input terminal 110 and the one end of the power inductor L71.

The switch S72 is an example of a twelfth switch and is connected between the one end of the power inductor L71 and ground. Specifically, the switch S72 has a terminal connected to the one end of the power inductor L71 via the inductor connection terminal 115, and a terminal connected to ground. In this connection configuration, ON/OFF switching of the switch S72 enables switching between connection and disconnection between the one end of the power inductor L71 and ground.

The switch S61 is connected between the other end of the power inductor L71 and the output terminal 111. Specifically, the switch S61 has a terminal connected to the other end of power inductor L71, and a terminal connected to the output terminal 111. In this connection configuration, ON/OFF switching of the switch S61 enables switching between connection and disconnection between the other end of the power inductor L71 and the output terminal 111.

The switch S62 is connected between the other end of the power inductor L71 and the output terminal 112. Specifically, the switch S62 has a terminal connected to the other end of power inductor L71, and a terminal connected to the output terminal 112. In this connection configuration, ON/OFF switching of the switch S62 enables switching between connection and disconnection between the other end of the power inductor L71 and the output terminal 112.

The switch S63 is connected between the other end of the power inductor L71 and the output terminal 113. Specifically, the switch S63 has a terminal connected to the other end of power inductor L71, and a terminal connected to the output terminal 113. In this connection configuration, ON/OFF switching of the switch S63 enables switching between connection and disconnection between the other end of the power inductor L71 and the output terminal 113.

One of the two electrodes of the capacitor C61 is connected to the switch S61 and the output terminal 111. The other of the two electrodes of the capacitor C61 is connected to the switch S62, the output terminal 112, and one of the two electrodes of the capacitor C62.

The one of the two electrodes of the capacitor C62 is connected to the switch S62, the output terminal 112, and the other of the two electrodes of the capacitor C61. The other of the two electrodes of the capacitor C62 is connected to a path connecting the switch S63, the output terminal 113, and one of the two electrodes of the capacitor C63.

The one of the two electrodes of the capacitor C63 is connected to the switch S63, the output terminal 113, and the other of the two electrodes of the capacitor C62. The other of the two electrodes of the capacitor C63 is connected to the output terminal 114 and one of the two electrodes of the capacitor C64.

The one of the two electrodes of the capacitor C64 is connected to the output terminal 114 and the other of the two electrodes of the capacitor C63. The other of the two electrodes of the capacitor C64 is connected to ground.

The switches S61 to S63 are controlled so as to be exclusively turned ON. In other words, only any one of the switches S61 to S63 is turned ON, and the others are turned OFF. Turning ON of only any one of the switches S61 to S63 enables the pre-regulator circuit 10 to change the voltage to be supplied to the switched-capacitor circuit 20 at the voltage levels of the voltages V2 to V4.

The pre-regulator circuit 10 configured as described above is capable of supplying electric charge to the switched-capacitor circuit 20 via at least one of the output terminals 111 to 113.

In a case where an input voltage is converted into one first voltage, it is sufficient that the pre-regulator circuit 10 include at least the switches S71 and S72 and the power inductor L71.

### [1.2.4. Circuit configuration of filter circuit 40]

Next, the circuit configuration of the filter circuit 40 will be described. As illustrated in Fig. 2, the filter circuit 40 is a resistor-inductor-capacitor (RLC) circuit, and includes inductors L51 to L53, capacitors C51 and C52, a resistor R51, an input terminal 140, and an output terminal 141.

The input terminal 140 is an input terminal for a voltage selected by the supply modulator 30. Specifically, the input terminal 140 is a terminal for receiving a voltage selected from among the plurality of voltages V1 to V4.

The output terminal 141 is an output terminal for the power supply voltage V_{ET}. Specifically, the output terminal 141 is a terminal for supplying the power supply voltage V_{ET} to the PA 2.

The inductors L51 to L53, the capacitors C51 and C52, and the resistor R51 constitute a low pass filter. Accordingly, the filter circuit 40 is capable of reducing RF components included in the power supply voltage. For example, when the predetermined band is a frequency band for frequency division duplex (FDD), the filter circuit 40 is configured to reduce frequency components of a gap between an uplink operating band and a downlink operating band of the predetermined band.

The configuration of the filter circuit 40 illustrated in Fig. 2 is illustrative, and is not restrictive. For example, the filter circuit 40 does not necessarily have to include the inductor L53 or the resistor R51. For example, the filter circuit 40 may include an inductor connected to one of the two electrodes of the capacitor C51, and may include an inductor connected to one of the two electrodes of the capacitor C52.

### [2. Description of digital ET mode]

The digital ET mode will be described with reference to Fig. 3A and Fig. 3B in comparison with a conventional ET mode (hereinafter referred to as an analog ET mode). Fig. 3A is a graph illustrating an example of transition of a power supply voltage in the digital ET mode. Fig. 3B is a graph illustrating an example of transition of a power supply voltage in the analog ET mode. In Fig. 3A and Fig. 3B, the horizontal axis represents time, and the vertical axis represents voltage. A thick solid line represents a power supply voltage, and a thin solid line (waveform) represents a modulated signal.

In the digital ET mode, as illustrated in Fig. 3A, the power supply voltage is varied to a plurality of discrete voltage levels within one frame to track the envelope of the modulated signal. As a result, the power supply voltage signal forms a rectangular wave. In the digital ET mode, a power supply voltage level is selected or set from among a plurality of discrete voltage levels, based on an envelope signal.

A frame means a unit constituting an RF signal (modulated signal). For example, in 5G NR and LTE, a frame includes 10 subframes, each subframe includes a plurality of slots, and each slot is composed of a plurality of symbols. The subframe has a length of 1 ms, and the frame has a length of 10 ms.

In the analog ET mode, as illustrated in Fig. 3B, the power supply voltage is continuously varied to track the envelope of the modulated signal. In the analog ET mode, the power supply voltage is determined based on an envelope signal. In the analog ET mode, when the envelope of the modulated signal changes at a high speed, it is difficult for the power supply voltage to track the envelope.

### [3. Disposition of components of tracker module 100]

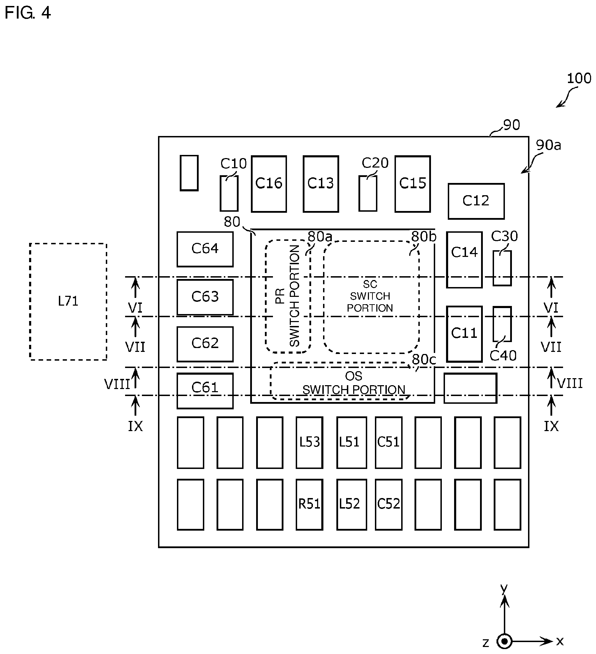

A tracker module 100 equipped with the pre-regulator circuit 10 (except for the power inductor L71), the switched-capacitor circuit 20, the supply modulator 30, and the filter circuit 40 will be described as an example of the power supply circuit 1 having the above-described configuration, with reference to Fig. 4 to Fig. 9. The power inductor L71 included in the pre-regulator circuit 10 is not included in the tracker module 100.

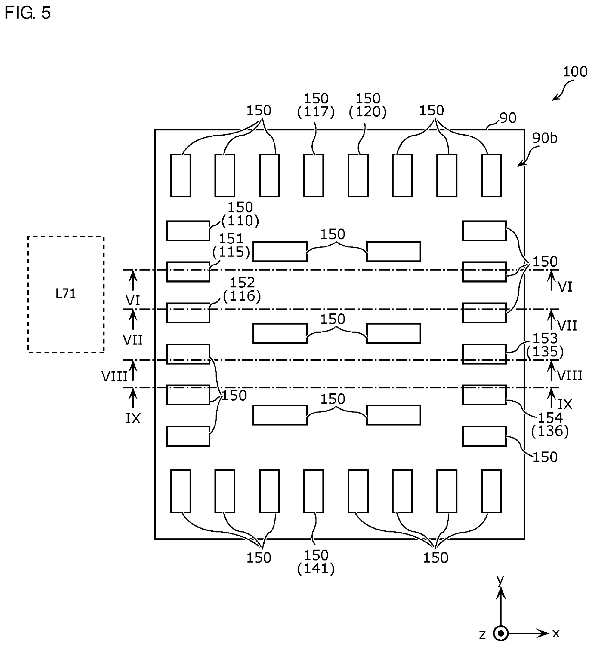

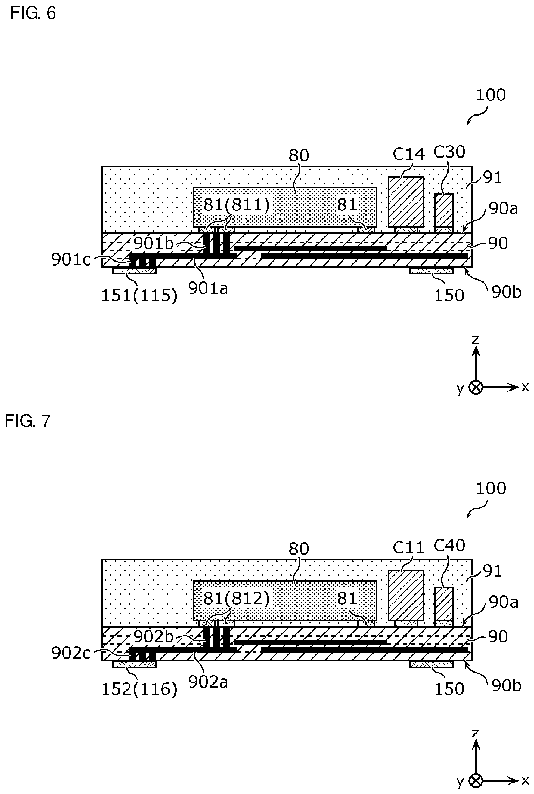

Fig. 4 is a plan view of the tracker module 100 according to the present example. Fig. 5 is a plan view of the tracker module 100 according to the present example, in which a main surface 90b side of a module substrate 90 is seen through from the positive side of the z-axis. Fig. 6 to Fig. 9 are each a sectional view of the tracker module 100 according to the present example. The sections of the tracker module 100 in Fig. 6 to Fig. 9 are sections taken along the line VI-VI, the line VII-VII, the line VIII-VIII, and the line IX-IX in Fig. 4 and Fig. 5, respectively.

In Fig. 4 and Fig. 5, the power inductor L71 outside the tracker module 100 is indicated by a broken line. The expression "outside the tracker module 100" means that the component is not disposed on or in the module substrate 90. That is, the power inductor L71 is not disposed on or in the module substrate 90 but is disposed on or in, for example, the same motherboard as that of the tracker module 100.

In Fig. 4 to Fig. 9, the illustration of some of wiring lines connecting a plurality of circuit components disposed on or in the module substrate 90 is omitted. In Fig. 4, the illustration of a resin member 91 covering the plurality of circuit components is omitted. In Fig. 4, the blocks not denoted by reference signs represent optional circuit components that are not essential to the present invention.

The tracker module 100 includes the module substrate 90, the resin member 91, and a plurality of land electrodes 150, in addition to the plurality of circuit components including active elements and passive elements (except for the power inductor L71) included in the pre-regulator circuit 10, the switched-capacitor circuit 20, the supply modulator 30, and the filter circuit 40 illustrated in Fig. 2.

The module substrate 90 has a main surface 90a and the main surface 90b opposed to each other. The module substrate 90 includes a wiring layer, via-conductors, a ground plane, and so forth formed therein. In Fig. 4 and Fig. 5, the module substrate 90 has a rectangular shape in plan view, but the shape is not limited thereto.

The module substrate 90 may be, but is not limited to, a low temperature co-fired ceramics (LTCC) substrate or a high temperature co-fired ceramics (HTCC) substrate having a multilayer structure of a plurality of dielectric layers, a component-embedded board, a substrate including a redistribution layer (RDL), a printed circuit board, or the like, for example.

On the main surface 90a, there are disposed an integrated circuit 80, the capacitors C10 to C16, C20, C30, C40, C51, C52, and C61 to C64, the inductors L51 to L53, the resistor R51, and the resin member 91.

The integrated circuit 80 includes a PR switch portion 80a, an SC switch portion 80b, an OS switch portion 80c, and a plurality of bump electrodes 81. The PR switch portion 80a includes the switches S61 to S63, S71, and S72. The SC switch portion 80b includes the switches S11 to S14, S21 to S24, S31 to S34, and S41 to S44. The OS switch portion 80c includes the switches S51 to S54.

Although the PR switch portion 80a, the SC switch portion 80b, and the OS switch portion 80c are included in the single integrated circuit 80 in Fig. 4, the present invention is not limited thereto. For example, the PR switch portion 80a and the SC switch portion 80b may be included in an integrated circuit, and the OS switch portion 80c may be included in another integrated circuit. Alternatively, for example, the SC switch portion 80b and the OS switch portion 80c may be included in an integrated circuit, and the PR switch portion 80a may be included in another integrated circuit. Alternatively, the PR switch portion 80a and the OS switch portion 80c may be included in an integrated circuit, and the SC switch portion 80b may be included in another integrated circuit. Alternatively, for example, the PR switch portion 80a, the SC switch portion 80b, and the OS switch portion 80c may be included in three respective integrated circuits.

In Fig. 4, the integrated circuit 80 has a rectangular shape in plan view of the module substrate 90, but the shape is not limited thereto.

The integrated circuit 80 is constituted by using, for example, complementary metal oxide semiconductor (CMOS), and specifically may be manufactured by a silicon on insulator (SOI) process. The integrated circuit 80 is not limited to CMOS.

The plurality of bump electrodes 81 are electrically connected to the plurality of electronic components disposed on the main surface 90a, the plurality of land electrodes 150 disposed on the main surface 90b, or the like via the wiring layer, the via-conductors, or the like formed in the module substrate 90. The plurality of bump electrodes 81 include bump electrodes 811 to 814.

The bump electrodes 811 are an example of a first integrated circuit (IC) terminal and are connected to the land electrode 150 functioning as the inductor connection terminal 115 (an example of a first external connection terminal). Specifically, as illustrated in Fig. 6, the bump electrodes 811 are connected to the land electrode 150 via six via-conductors 901b disposed on the main surface 90a side in the module substrate 90, a wiring line 901a (an example of a first wiring line) disposed in the wiring layer in the module substrate 90, and six via-conductors 901c disposed on the main surface 90b side in the module substrate 90. The number of the via-conductors 901b and the number of the via-conductors 901c are not limited to six, and may be any number. The number of the via-conductors 901b and the number of the via-conductors 902c are not necessarily the same.

The bump electrodes 812 are an example of a first IC terminal and are connected to the land electrode 150 functioning as the inductor connection terminal 116 (an example of a first external connection terminal). Specifically, as illustrated in Fig. 7, the bump electrodes 812 are connected to the land electrode 150 via six via-conductors 902b disposed on the main surface 90a side in the module substrate 90, a wiring line 902a (an example of a first wiring line) disposed in the wiring layer in the module substrate 90, and six via-conductors 902c disposed on the main surface 90b side in the module substrate 90. The number of the via-conductors 902b and the number of the via-conductors 902c are not limited to six, and may be any number. The number of the via-conductors 902b and the number of the via-conductors 902c are not necessarily the same.

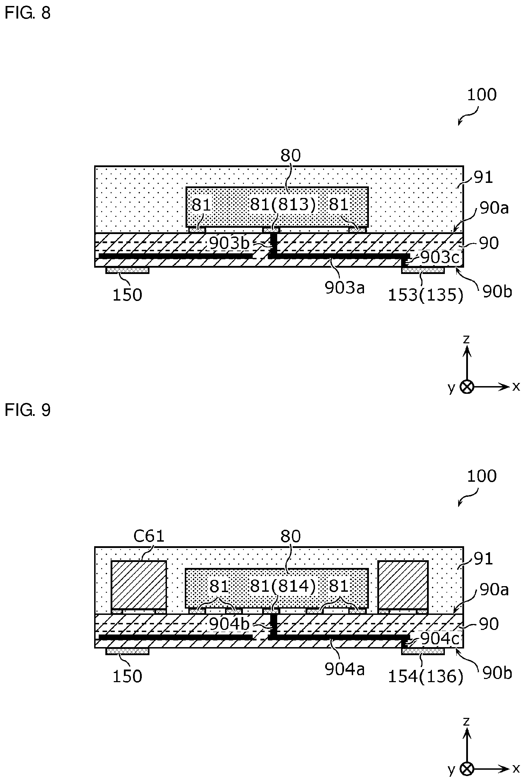

The bump electrode 813 is an example of a second IC terminal and is connected to the land electrode 150 functioning as the control terminal 135 (an example of a second external connection terminal). Specifically, as illustrated in Fig. 8, the bump electrode 813 is connected to the land electrode 150 via one via-conductor 903b disposed on the main surface 90a side in the module substrate 90, a wiring line 903a (an example of a second wiring line) disposed in the wiring layer in the module substrate 90, and one via-conductor 903c disposed on the main surface 90b side in the module substrate 90. The number of the via-conductors 903b and 903c is smaller than the number of the via-conductors 901b and 901c and is smaller than the number of the via-conductors 902b and 902c.

The bump electrode 814 is an example of a second IC terminal and is connected to the land electrode 150 functioning as the control terminal 136 (an example of a second external connection terminal). Specifically, as illustrated in Fig. 9, the bump electrode 814 is connected to the land electrode 150 via one via-conductor 904b disposed on the main surface 90a side in the module substrate 90, a wiring line 904a (an example of a second wiring line) disposed in the wiring layer in the module substrate 90, and one via-conductor 904c disposed on the main surface 90b side in the module substrate 90. The number of the via-conductors 904b and 904c is smaller than the number of the via-conductors 901b and 901c and is smaller than the number of the via-conductors 902b and 902c.

The capacitors C10 to C16, C20, C30, C40, C51, C52, and C61 to C64 are each mounted as a chip capacitor. The chip capacitor means a surface mount device (SMD) constituting a capacitor. The implementation of the plurality of capacitors is not limited to chip capacitors. For example, the plurality of capacitors may be included in an integrated passive device (IPD).

The inductors L51 to L53 are each mounted as a chip inductor. The chip inductor means an SMD constituting an inductor. The implementation of the plurality of inductors is not limited to chip inductors. For example, the plurality of inductors may be included in an IPD.

The resistor R51 is mounted as a chip resistor. The chip resistor means an SMD constituting a resistor. The implementation of the resistor R51 is not limited to a chip resistor. For example, the resistor R51 may be included in an IPD.

In this way, the plurality of capacitors, the plurality of inductors, and the resistor disposed on the main surface 90a are grouped for the individual circuits and disposed around the integrated circuit 80.

Specifically, a group of the capacitors C61 to C64 included in the pre-regulator circuit 10 is disposed in a region on the main surface 90a sandwiched between a straight line along the left side of the integrated circuit 80 and a straight line along the left side of the module substrate 90 in plan view of the module substrate 90. Accordingly, a group of the circuit components included in the pre-regulator circuit 10 is disposed near the PR switch portion 80a in the integrated circuit 80.

A group of the capacitors C10 to C16, C20, C30, and C40 included in the switched-capacitor circuit 20 is disposed in a region on the main surface 90a sandwiched between a straight line along the upper side of the integrated circuit 80 and a straight line along the upper side of the module substrate 90, and a region on the main surface 90a sandwiched between a straight line along the right side of the integrated circuit 80 and a straight line along the right side of the module substrate 90, in plan view of the module substrate 90. Accordingly, a group of the circuit components included in the switched-capacitor circuit 20 is disposed near the SC switch portion 80b in the integrated circuit 80.

A group of the capacitors C51 and C52, the inductors L51 to L53, and the resistor R51 included in the filter circuit 40 is disposed in a region on the main surface 90a sandwiched between a straight line along the lower side of the integrated circuit 80 and a straight line along the lower side of the module substrate 90 in plan view of the module substrate 90. Accordingly, a group of the circuit components included in the switched-capacitor circuit 20 is disposed near the OS switch portion 80c in the integrated circuit 80.

The plurality of land electrodes 150 are disposed on the main surface 90b. The plurality of land electrodes 150 function as a plurality of external connection terminals including a ground terminal in addition to the input terminal 110, the output terminal 141, the inductor connection terminals 115 and 116, and the control terminals 117, 120, 135, and 136 illustrated in Fig. 2. The plurality of land electrodes 150 are electrically connected to the plurality of electronic components disposed on the main surface 90a via the via-conductors or the like formed in the module substrate 90. The plurality of land electrodes 150 may be, but are not limited to, copper electrodes. For example, the plurality of land electrodes may be solder electrodes. Instead of the plurality of land electrodes 150, a plurality of bump electrodes or a plurality of post electrodes may be used as the plurality of external connection terminals.

The plurality of land electrodes 150 include land electrodes 151 to 154. The land electrode 151 is an example of a first external connection terminal and functions as the inductor connection terminal 115. The land electrode 152 is an example of a first external connection terminal and functions as the inductor connection terminal 116. The land electrode 153 is an example of a second external connection terminal and functions as the control terminal 135. The land electrode 154 is an example of a second external connection terminal and functions as the control terminal 136.

The resin member 91 covers the main surface 90a and at least a part of the plurality of electronic components on the main surface 90a. The resin member 91 has a function of ensuring reliability, such as mechanical strength and moisture resistance, of the plurality of electronic components on the main surface 90a. The resin member 91 does not necessarily have to be included in the tracker module 100.

The configuration of the tracker module 100 according to the present example is illustrative, and is not restrictive. For example, one or some of the capacitors and inductors disposed on the main surface 90a may be formed in the module substrate 90. In addition, one or some of the capacitors and inductors disposed on the main surface 90a do not necessarily have to be included in the tracker module 100, and do not necessarily have to be disposed on or in the module substrate 90.

### [4. Positional relationship between electrodes and wiring lines]

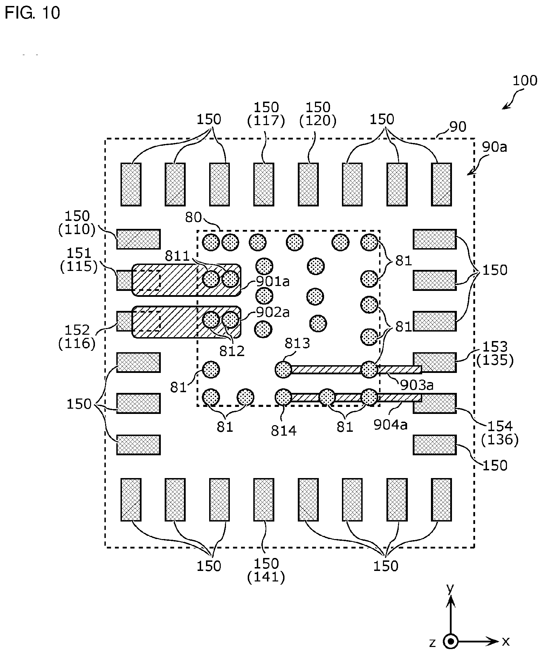

Now, the positional relationship among the plurality of land electrodes 150, the plurality of bump electrodes 81, and the wiring lines 901a to 904a in the module substrate 90 will be described with reference to Fig. 10 to Fig. 14.

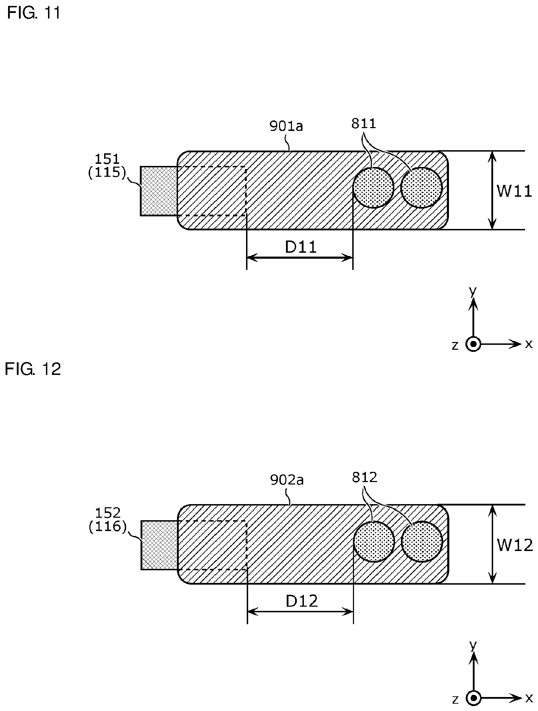

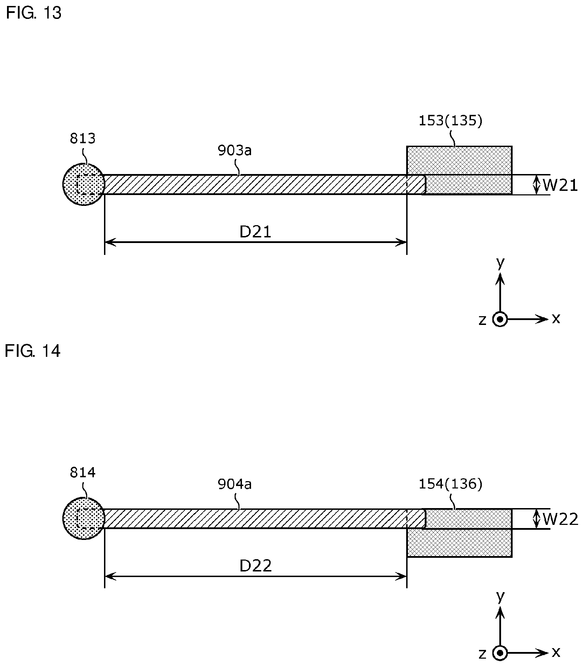

FIG. 10 is a plan view of the plurality of electrodes and the plurality of wiring lines included in the tracker module 100 according to the present example. Fig. 11 is an enlarged plan view of the land electrode 151, the bump electrodes 811, and the wiring line 901a connecting the land electrode 151 and the bump electrodes 811 included in the tracker module 100 according to the present example. Fig. 12 is an enlarged plan view of the land electrode 152, the bump electrodes 812, and the wiring line 902a connecting the land electrode 152 and the bump electrodes 812 included in the tracker module 100 according to the present example. Fig. 13 is an enlarged plan view of the land electrode 153, the bump electrode 813, and the wiring line 903a connecting the land electrode 153 and the bump electrode 813 included in the tracker module 100 according to the present example. Fig. 14 is an enlarged plan view of the land electrode 154, the bump electrode 814, and the wiring line 904a connecting the land electrode 154 and the bump electrode 814 included in the tracker module 100 according to the present example. In Fig. 10, the illustration of the six land electrodes 150 disposed in a central region of the module substrate 90 is omitted.

As illustrated in Fig. 10 and Fig. 11, a distance D11 is an example of a first distance, and is the distance between the land electrode 151 functioning as the inductor connection terminal 115 and the two bump electrodes 811 connected to the land electrode 151 via the wiring line 901a. The distance D11 is obtained by measuring the shortest distance between the land electrode 151 and the two bump electrodes 811. That is, the distance D11 is obtained by measuring the length of the shortest line segment among a plurality of line segments connecting certain points on the surface of the land electrode 151 and certain points on the surfaces of the two bump electrodes 811.

A width W11 is the width of the wiring line 901a in plan view of the module substrate 90. The width W11 is obtained by measuring the length in a predetermined direction of the region of the wiring line 901a orthographically projected on the xy plane. The predetermined direction is defined as a direction perpendicular to a line segment representing the shortest distance between the land electrode 151 and the two bump electrodes 811. In Fig. 11, the line segment representing the shortest distance between the land electrode 151 and the two bump electrodes 811 is parallel to the x-axis, and thus the predetermined direction is the y-direction.

As illustrated in Fig. 10 and Fig. 12, a distance D12 is an example of a first distance, and is the distance between the land electrode 152 functioning as the inductor connection terminal 116 and the two bump electrodes 812 connected to the land electrode 152 via the wiring line 902a. The distance D12 is obtained by measuring the shortest distance between the land electrode 152 and the two bump electrodes 812. That is, the distance D12 is obtained by measuring the length of the shortest line segment among a plurality of line segments connecting certain points on the surface of the land electrode 152 and certain points on the surfaces of the two bump electrodes 812.

A width W12 is the width of the wiring line 902a in plan view of the module substrate 90. The width W12 is obtained by measuring the length in a predetermined direction of the region of the wiring line 902a orthographically projected on the xy plane. The predetermined direction is defined as a direction perpendicular to a line segment representing the shortest distance between the land electrode 152 and the two bump electrodes 812. In Fig. 12, the line segment representing the shortest distance between the land electrode 152 and the two bump electrodes 812 is parallel to the x-axis, and thus the predetermined direction is the y-direction.

As illustrated in Fig. 10 and Fig. 13, a distance D21 is an example of a second distance, and is the distance between the land electrode 153 functioning as the control terminal 135 and the bump electrode 813 connected to the land electrode 153 via the wiring line 903a. The distance D21 is obtained by measuring the shortest distance between the land electrode 153 and the bump electrode 813. That is, the distance D21 is obtained by measuring the length of the shortest line segment among a plurality of line segments connecting certain points on the surface of the land electrode 153 and certain points on the surface of the bump electrode 813.

A width W21 is the width of the wiring line 903a in plan view of the module substrate 90. The width W21 is obtained by measuring the length in a predetermined direction of the region of the wiring line 903a orthographically projected on the xy plane. The predetermined direction is defined as a direction perpendicular to a line segment representing the shortest distance between the land electrode 153 and the bump electrodes 813. In Fig. 13, the line segment representing the shortest distance between the land electrode 153 and the bump electrode 813 is parallel to the x-axis, and thus the predetermined direction is the y-direction.

As illustrated in Fig. 10 and Fig. 14, a distance D22 is an example of a second distance, and is the distance between the land electrode 154 functioning as the control terminal 136 and the bump electrode 814 connected to the land electrode 154 via the wiring line 904a. The distance D22 is obtained by measuring the shortest distance between the land electrode 154 and the bump electrode 814. That is, the distance D22 is obtained by measuring the length of the shortest line segment among a plurality of line segments connecting certain points on the surface of the land electrode 154 and certain points on the surface of the bump electrode 814.

A width W22 is the width of the wiring line 904a in plan view of the module substrate 90. The width W22 is obtained by measuring the length in a predetermined direction of the region of the wiring line 904a orthographically projected on the xy plane. The predetermined direction is defined as a direction perpendicular to a line segment representing the shortest distance between the land electrode 154 and the bump electrode 814. In Fig. 14, the line segment representing the shortest distance between the land electrode 154 and the bump electrode 814 is parallel to the x-axis, and thus the predetermined direction is the y-direction.

### [5. Advantageous effects and the like]

As described above, the tracker module 100 according to the present example includes the module substrate 90, the integrated circuit 80 disposed on or in the module substrate 90, and the plurality of land electrodes 150 including the land electrodes 151 and 153. The integrated circuit 80 includes at least one switch included in the pre-regulator circuit 10 configured to convert an input voltage into a first voltage by using the power inductor L71; at least one switch included in the switched-capacitor circuit 20 configured to generate a plurality of discrete voltages from the first voltage; at least one switch included in the supply modulator 30 configured to selectively output, based on a digital control signal corresponding to an envelope signal, at least one of the plurality of discrete voltages; the bump electrodes 811 connected to the land electrode 151; and the bump electrode 813 connected to the land electrode 153. The land electrode 151 is connected to the power inductor L71 that is disposed outside the tracker module 100. The land electrode 153 is an input terminal for the digital control signal. The distance D11 between the land electrode 151 and the bump electrodes 811 is shorter than the distance D21 between the land electrode 153 and the bump electrode 813.

From another viewpoint, the tracker module 100 according to the present example includes the module substrate 90, the integrated circuit 80 disposed on or in the module substrate 90, and the plurality of land electrodes 150 including the land electrodes 151 and 153. The integrated circuit 80 includes at least one switch included in the pre-regulator circuit 10, at least one switch included in the switched-capacitor circuit 20, at least one switch included in the supply modulator 30, the bump electrodes 811 connected to the land electrode 151, and the bump electrode 813 connected to the land electrode 153. The switched-capacitor circuit 20 includes the capacitor C12 having two electrodes, and the capacitor C15 having two electrodes. The at least one switch included in the switched-capacitor circuit 20 includes the switches S21 to S24 and S31 to S34. One terminal of the switch S21 and one terminal of the switch S22 are connected to one of the two electrodes of the capacitor C12. One terminal of the switch S32 and one terminal of the switch S31 are connected to the other of the two electrodes of the capacitor C12. One terminal of the switch S23 and one terminal of the switch S24 are connected to one of the two electrodes of the capacitor C15. One terminal of the switch S34 and one terminal of the switch S33 are connected to the other of the two electrodes of the capacitor C15. The other terminal of the switch S21, the other terminal of the switch S32, the other terminal of the switch S23, and the other terminal of the switch S34 are connected to each other. The other terminal of the switch S22 is connected to the other terminal of the switch S24. The other terminal of the switch S31 is connected to the other terminal of the switch S33. The supply modulator 30 includes the output terminal 130. The at least one switch included in the supply modulator 30 includes the switch S53 connected between the output terminal 130 and each of the other terminal of the switch S21, the other terminal of the switch S32, the other terminal of the switch S23, and the other terminal of the switch S34; and the switch S52 connected between the output terminal 130 and each of the other terminal of the switch S22 and the other terminal of the switch S24. The pre-regulator circuit 10 includes the input terminal 110. The at least one switch included in the pre-regulator circuit 10 includes the switch S71 connected between the input terminal 110 and one end of the power inductor L71; the switch S72 connected between the one end of the power inductor L71 and ground; and the switch S63 connected between the other end of the power inductor L71 and each of the other terminal of the switch S21, the other terminal of the switch S32, the other terminal of the switch S23, and the other terminal of the switch S34. The land electrode 151 is connected to the power inductor L71 that is disposed outside the tracker module 100. The land electrode 153 is an input terminal for a digital control signal for the supply modulator 30. The distance D11 between the land electrode 151 and the bump electrodes 811 is shorter than the distance D21 between the land electrode 153 and the bump electrode 813.

Accordingly, the distance D11 between the land electrode 151 connected to the power inductor L71 that is disposed outside the tracker module 100 and the bump electrodes 811 of the integrated circuit 80 connected to the land electrode 151 can be made relatively short. The minimum length of the wiring line 901a between the land electrode 151 and the bump electrodes 811 is limited by the distance D11. Thus, the distance D11 that is relatively short makes it possible to make the length of the wiring line 901a between the land electrode 151 and the bump electrodes 811 relatively short. As a result, the resistance loss in the wiring line between the land electrode 151 and the bump electrodes 811 can be reduced. In particular, a relatively large current flows through the wiring line 901a between the land electrode 151 connected to the power inductor L71 and the bump electrodes 811, and thus the effect of reducing the resistance loss is large. On the other hand, the distance D21 between the land electrode 153 to which a digital control signal is transmitted and the bump electrode 813 of the integrated circuit 80 connected to the land electrode 153 is relatively long. However, only a relatively small current flows through the wiring line 903a between the land electrode 153 to which a digital control signal is transmitted and the bump electrode 813, and thus an influence of the increase in the wiring length on the resistance loss is small. Thus, the tracker module 100 is capable of reducing deterioration of characteristics related to the connection between the integrated circuit 80 in the tracker module 100 and the power inductor L71 that is disposed outside the tracker module 100.

For example, in the tracker module 100 according to the present example, in plan view of the module substrate 90, the width W11 of the wiring line 901a connecting the land electrode 151 and the bump electrodes 811 may be larger than the width W21 of the wiring line 903a connecting the land electrode 153 and the bump electrode 813.

Accordingly, the resistance loss in the wiring line between the land electrode 151 and the bump electrodes 811 can be further reduced.

For example, in the tracker module 100 according to the present example, the digital control signal may include a plurality of DCL signals indicating one of the plurality of second voltages. The plurality of land electrodes 150 may include the land electrodes 153 and 154 each being provided for a corresponding one of the plurality of DCL signals. The integrated circuit 80 may include the bump electrodes 813 and 814 connected to the land electrodes 153 and 154, respectively.

Accordingly, a plurality of DCL signals are used as a digital control signal. The DCL signal does not require a clock signal, and thus the wiring line 903a for transmitting the DCL signal is less likely to generate noise. Thus, it is possible to reduce an influence of noise caused by a relatively large length of the wiring line 903a.

For example, in the tracker module 100 according to the present example, the distance D11 may be shorter than each of the distance D21 between the land electrode 153 and the bump electrode 813 connected to each other and the distance D22 between the land electrode 154 and the bump electrode 814 connected to each other.

Accordingly, the distance D11 is shorter than each of the distances D21 and D22 between electrodes that transmit a plurality of DCL signals, and thus the distance D11 can be made shorter than the length of the wiring line 901a between the land electrode 151 and the bump electrodes 811.

For example, in the tracker module 100 according to the present example, the plurality of land electrodes 150 may include the two land electrodes 151 and 152 respectively connected to one end and the other end of the power inductor L71. The integrated circuit 80 may include the two bump electrodes 811 and the two bump electrodes 812 respectively connected to the two land electrodes 151 and 152. Each of the distance D11 between the land electrode 151 and the bump electrodes 811 connected to each other and the distance D12 between the land electrode 152 and the bump electrodes 812 connected to each other may be shorter than the distance D21.

Accordingly, in addition to the wiring line 901a, the wiring line 902a between the land electrode 152 connected to the power inductor L71 and the bump electrodes 812 can be made relatively short, and thus the resistance loss can be further reduced.

For example, in the tracker module 100 according to the present example, the integrated circuit 80 may be a single integrated circuit.

Accordingly, the switches included in the pre-regulator circuit 10, the switched-capacitor circuit 20, and the supply modulator 30 can be integrated in the single integrated circuit 80, which can contribute to miniaturization of the tracker module 100.

### (Other embodiments)

The tracker module according to the present invention has been described above based on an embodiment and an example. The tracker module according to the present invention is not limited to the above embodiment and the above example. Another embodiment and another example implemented by combining any constituent elements in the above embodiment and the above example, modifications obtained by applying various changes conceived by those skilled in the art to the above embodiment and the above example without departing from the gist of the present invention, and various devices including the above-described tracker module are also included in the present invention.

For example, in the circuit configurations of the various circuits according to the above embodiment, another circuit element, wiring line, and the like may be inserted between individual circuit elements and paths connecting signal paths disclosed in the drawings. For example, an impedance matching circuit may be inserted between the PA 2 and the filter 3 and/or between the filter 3 and the antenna 6.

### Industrial Applicability

The present invention can be widely used, as a tracker module for supplying a power supply voltage to a power amplifier, in communication devices such as mobile phones. Reference Signs List

1 power supply circuit
2 power amplifier
3 filter
4 PA control circuit
5 RFIC
6 antenna
7 communication device
10 pre-regulator circuit
20 switched-capacitor circuit
30 supply modulator
40 filter circuit
50 DC power source
80 integrated circuit
80a PR switch portion
80b SC switch portion
80c OS switch portion
81, 811, 812, 813, 814 bump electrode
90 module substrate
90a, 90b main surface
91 resin member
100 tracker module
110, 131, 132, 133, 134, 140 input terminal
111, 112, 113, 114, 130, 141 output terminal
115, 116 inductor connection terminal
117, 120, 135, 136 control terminal
150, 151, 152, 153, 154 land electrode
901a, 902a, 903a, 904a wiring line
901b, 902b, 903b, 904b, 901c, 902c, 903c, 904 via-conductor
C10, C11, C12, C13, C14, C15, C16, C20, C30, C40, C51, C52, C61, C62, C63, C64 capacitor
D11, D12, D21, D22 distance
L51, L52, L53 inductor
L71 power inductor
N1, N2, N3, N4 node
R51 resistor
S11, S12, S13, S14, S21, S22, S23, S24, S31, S32, S33, S34, S41, S42, S43, S44, S51, S52, S53, S54, S61, S62, S63, S71, S72 switch
V1, V2, V3, V4 voltage
W11, W12, W21, W22 width

## Claims

1. A tracker module comprising:
a module substrate;
at least one integrated circuit disposed on or in the module substrate; and
a plurality of external connection terminals including a first external connection terminal and a second external connection terminal, wherein
the at least one integrated circuit includes:
at least one switch included in a pre-regulator circuit configured to convert an input voltage into a first voltage by using a power inductor;
at least one switch included in a switched-capacitor circuit configured to generate a plurality of discrete voltages from the first voltage;
at least one switch included in a supply modulator configured to selectively output, based on a digital control signal corresponding to an envelope signal, at least one of the plurality of discrete voltages;
a first integrated circuit terminal connected to the first external connection terminal; and
a second integrated circuit terminal connected to the second external connection terminal,
the first external connection terminal is connected to the power inductor that is disposed outside the tracker module,
the second external connection terminal is an input terminal for the digital control signal, and
a first distance between the first external connection terminal and the first integrated circuit terminal is shorter than a second distance between the second external connection terminal and the second integrated circuit terminal.

2. The tracker module according to Claim 1, wherein
in plan view of the module substrate, a width of a first wiring line connecting the first external connection terminal and the first integrated circuit terminal is larger than a width of a second wiring line connecting the second external connection terminal and the second integrated circuit terminal.

3. The tracker module according to Claim 1 or 2, wherein
the digital control signal includes a plurality of digitally controlled level signals indicating one of the plurality of second voltages,
the plurality of external connection terminals include a plurality of second external connection terminals each being provided for a corresponding one of the plurality of digitally controlled level signals, and
the at least one integrated circuit includes a plurality of second integrated circuit terminals each being connected to a corresponding one of the plurality of second external connection terminals.

4. The tracker module according to Claim 3, wherein
the first distance is shorter than any of a plurality of second distances between the plurality of second external connection terminals and the plurality of second integrated circuit terminals connected to each other.

5. The tracker module according to Claim 1 or 2, wherein
the plurality of external connection terminals include two first external connection terminals respectively connected to one end and an other end of the power inductor,
the at least one integrated circuit includes two first integrated circuit terminals respectively connected to the two first external connection terminals, and
each of two first distances between the two first external connection terminals and the two first integrated circuit terminals connected to each other is shorter than the second distance.

6. The tracker module according to any one of Claims 1 to 5, wherein
the at least one integrated circuit is a single integrated circuit.

7. A tracker module comprising:
a module substrate;
at least one integrated circuit disposed on or in the module substrate; and
a plurality of external connection terminals including a first external connection terminal and a second external connection terminal, wherein
the at least one integrated circuit includes:
at least one switch included in a pre-regulator circuit;
at least one switch included in a switched-capacitor circuit;
at least one switch included in a supply modulator;
a first integrated circuit terminal connected to the first external connection terminal; and
a second integrated circuit terminal connected to the second external connection terminal,
the switched-capacitor circuit includes:
a first capacitor having a first electrode and a second electrode; and
a second capacitor having a third electrode and a fourth electrode,
the at least one switch included in the switched-capacitor circuit includes a first switch, a second switch, a third switch, a fourth switch, a fifth switch, a sixth switch, a seventh switch, and an eighth switch,
one terminal of the first switch and one terminal of the third switch are connected to the first electrode,
one terminal of the second switch and one terminal of the fourth switch are connected to the second electrode,
one terminal of the fifth switch and one terminal of the seventh switch are connected to the third electrode,
one terminal of the sixth switch and one terminal of the eighth switch are connected to the fourth electrode,
an other terminal of the first switch, an other terminal of the second switch, an other terminal of the fifth switch, and an other terminal of the sixth switch are connected to each other,
an other terminal of the third switch is connected to an other terminal of the seventh switch,
an other terminal of the fourth switch is connected to an other terminal of the eighth switch,
the supply modulator includes an output terminal,
the at least one switch included in the supply modulator includes:
a ninth switch connected between the output terminal and each of the other terminal of the first switch, the other terminal of the second switch, the other terminal of the fifth switch, and the other terminal of the sixth switch; and
a tenth switch connected between the output terminal and each of the other terminal of the third switch and the other terminal of the seventh switch,
the pre-regulator circuit includes an input terminal,
the at least one switch included in the pre-regulator circuit includes:
an eleventh switch connected between the input terminal and one end of a power inductor; and
a twelfth switch connected between the one end of the power inductor and ground,
an other end of the power inductor is connected to the other terminal of the first switch, the other terminal of the second switch, the other terminal of the fifth switch, and the other terminal of the sixth switch,
the first external connection terminal is connected to the power inductor that is disposed outside the tracker module,
the second external connection terminal is an input terminal for a digital control signal for the supply modulator, and
a first distance between the first external connection terminal and the first integrated circuit terminal is shorter than a second distance between the second external connection terminal and the second integrated circuit terminal.

8. The tracker module according to Claim 7, wherein
in plan view of the module substrate, a width of a first wiring line connecting the first external connection terminal and the first integrated circuit terminal is larger than a width of a second wiring line connecting the second external connection terminal and the second integrated circuit terminal.

9. The tracker module according to Claim 7 or 8, wherein
the digital control signal includes a plurality of digitally controlled level signals indicating one of a plurality of discrete voltage levels,
the plurality of external connection terminals include a plurality of second external connection terminals each being provided for a corresponding one of the plurality of digitally controlled level signals, and
the at least one integrated circuit includes a plurality of second integrated circuit terminals each being connected to a corresponding one of the plurality of second external connection terminals.

10. The tracker module according to Claim 9, wherein
the first distance is shorter than any of a plurality of second distances between the plurality of second external connection terminals and the plurality of second integrated circuit terminals connected to each other.

11. The tracker module according to Claim 7 or 8, wherein
the plurality of external connection terminals include two first external connection terminals respectively connected to the one end and the other end of the power inductor,
the at least one integrated circuit includes two first integrated circuit terminals respectively connected to the two first external connection terminals, and
each of two first distances between the two first external connection terminals and the two first integrated circuit terminals connected to each other is shorter than the second distance.

12. The tracker module according to any one of Claims 7 to 11, wherein
the at least one integrated circuit is a single integrated circuit.
